(19) Europäisches Patentamt
European Patent Office
Office européen des brevets

(11) Numéro de publication : **0 486 393 A1**

(12) **DEMANDE DE BREVET EUROPEEN**

(21) Numéro de dépôt : **91403057.2**

(22) Date de dépôt : **14.11.91**

(51) Int. Cl.$^5$ : **C04B 41/87,** B05B 17/06, B05D 1/02, C03B 19/12, C03B 37/016, C03C 17/00, C09D 1/00, C09D 183/00, C23C 18/00, H01L 39/24

(30) Priorité : **16.11.90 FR 9014312**

(43) Date de publication de la demande : **20.05.92 Bulletin 92/21**

(84) Etats contractants désignés : **DE ES GB IT NL SE**

(71) Demandeur : **CENTRE NATIONAL DE LA RECHERCHE SCIENTIFIQUE**
**15, quai Anatole France**
**F-75007 Paris (FR)**

(71) Demandeur : **COMMISSARIAT A L'ENERGIE ATOMIQUE**
**31-33, rue de la Fédération**
**F-75015 Paris (FR)**

(72) Inventeur : **Langlet, Michel**
**22 rue F. Esclangon**
**F-38000 Grenoble (FR)**
Inventeur : **Joubert, Jean-Claude**
**Le Planchon**
**F-38610 Venon (FR)**

(74) Mandataire : **Mongrédien, André et al**
**c/o BREVATOME 25, rue de Ponthieu**
**F-75008 Paris (FR)**

(54) **Procédé sol-gel de dépôt de couches minces par pulvérisation ultrasonore.**

(57) Le procédé comporte les étapes suivantes : préparation d'une solution contenant au moins un solvant et au moins un précurseur du polymère soluble dans le solvant, la concentration totale en précurseur étant de 0,05 à 2 mol/l ; pulvérisation (12) ultrasonore à haute fréquence, dans un réacteur fermé étanche (18), de la solution au-dessus du substrat (24) entraînant le dépot d'un sol dudit précurseur sur le substrat, celui-ci étant maintenu à une température inférieure à la température d'ébullition du solvant, et séchage (28) du sol déposé pour évaporer le solvant et former ainsi une couche solide dudit polymère. En particulier, le précurseur est un monomère. Eventuellement, un recuit du dépôt polymère peut être effectué en vue d'obtenir un dépot inorganique et plus spécialement d'oxydes métalliques sons forme de verre, de vitrocéramique ou de céramique.

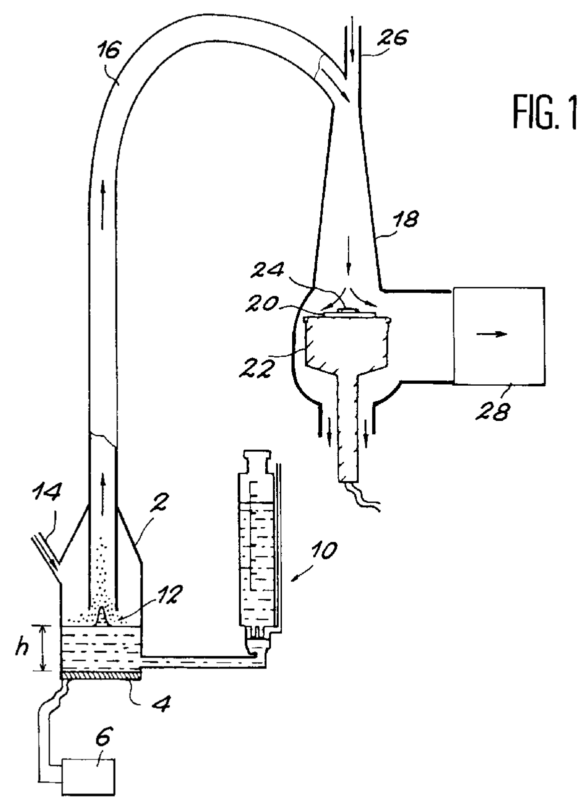


FIG. 1

EP 0 486 393 A1

L'invention a pour objet un procédé sol-gel de dépôt de couches minces de polymère à partir d'un aérosol produit par pulvérisation ultrasonore, permettant en particulier, après traitement thermique du dépôt polymère, d'obtenir des couches minces inorganiques et plus spécialement d'oxydes métalliques. Ces couches inorganiques peuvent être cristallines ou amorphes et se présenter sous forme de verre, de vitrocéramique ou de céramique.

Les couches minces d'oxyde obtenues peuvent être utilisées dans un grand nombre d'applications et en particulier dans le domaine optique pour constituer des revêtements transparents à haut ou bas indice de réfraction, employés notamment dans des guides optiques, des couches fortement réflectrices ou anti-réflectrices utilisées notamment dans des dispositifs laser de haute puissance, des couches sélectives ou encore des gaines pour fibres optiques ("clading") ; dans le domaine de la microélectronique ou de l'optoélectronique, comme revêtement à propriété diélectrique, pyroélectrique, piézoélectrique ou ferroélectrique pour la réalisation de guides d'onde acoustiques, de dispositifs électrooptiques (guides d'onde, mémorisation, commutateurs, modulateurs), de condensateurs intégrés ou encore de détecteurs infrarouges.

Dans le domaine de la microélectronique, les couches minces sont en particulier du type $PbTiO_3$, $BaTiO_3$, PZT (titanate de plomb et de zirconium), PLZT (titanate de zirconium, de plomb et de lanthane).

Dans le domaine de l'optique, les couches minces sont en particulier du type $SiO_2$, $TiO_2$, $ZrO_2$ et leurs combinaisons.

Les couches minces obtenues par l'invention peuvent aussi être utilisées comme revêtement de surface pour la protection chimique, thermique ou mécanique de certains matériaux (protection anti-abrasive ou anticorrosive) ; ces couches sont alors des céramiques transparentes ($ZrO_2$, $Al_2O_3$) ou des verres mixtes ($ZrO_2$-$SiO_2$, $Al_2O_3$-$SiO_2$, $TiO_2$-$SiO_2$).

L'invention permet en outre, après traitement thermique de la couche polymérique, l'obtention de couches minérales non oxydes telles que des couches de fluorure de calcium ou de magnésium, mais aussi des couches de carbure, de nitrure, de carbonitrure, d'oxynitrure. Ces dernières couches sont destinées essentiellement à la protection chimique, thermique ou mécanique.

L'invention permet encore, après traitement du dépôt polymère, l'obtention de couches de verres ou de céramiques organiques.

De façon plus précise, l'invention s'applique à un procédé sol-gel de dépôt en couches minces de polymères organiques, minéraux ou encore organométalliques.

Depuis une vingtaine d'années, de nombreux brevets et publications ont décrit l'application du procédé sol-gel pour l'obtention de matériaux polymères, vitreux, vitrocéramiques ou céramiques se présentant sous forme de pièces massives, de poudres fines, de fibres ou de couches minces.

En particulier, on peut citer l'article de H. DISLICH, Journal of Non-Crystalline Solids 57 (1983), p. 371-388, "Glassy and crystalline systems from gels : Chemical basis and Technical application" ; l'article de H.G. FLOCH et al., le Vide, les Couches Minces, n°245, janvier-février 1989, p. 33-43, "$TiO_2$-$SiO_2$ colloïdal HR-films for high power lasers" ; ou encore l'article de S.L. SWARTZ et al., Mat. Res. Soc. Symp. Proc., vol. 152, (1989), p. 227-232, "Ferroelectric thin films by sol-gel processing".

On rappelle qu'un sol est une solution colloïdale apparaîssant avant la gélification et qu'un gel est une masse visqueuse-élastique formée à partir de suspensions colloïdales ; il présente une structure de liquide figé.

La mise en oeuvre du procédé sol-gel dans le domaine des couches minces est essentiellement limitée à deux types de techniques de dépôt (voir à cet effet l'article ci-dessus de FLOCH). Ces techniques consistent en l'étalement par centrifugation (spin coating en terminologie anglo-saxonne) ou par tirage (dip coating) d'une solution liquide précurseur des constituants des couches minces. Ces deux techniques de dépôt présentent un certain nombre d'inconvénients.

En particulier, les possibilités de contrôle des conditions du dépôt sont assez limitées. En effet, un revêtement par étalement ne permet pas un contrôle d'épaisseur aussi précis que dans le cas d'une croissance continue de dépôt (telle qu'une croissance en phase vapeur).

De plus, l'étalement, l'épaisseur et l'adhérence du dépôt sont essentiellement liés à la viscosité de la solution et à la vitesse de rotation du substrat pour l'étalement par centrifugation et à celle du tirage du substrat pour l'étalement par tirage, ce qui rend critique les conditions opératoires.

En outre, ces techniques de dépôt sol-gel sont limitées au recouvrement de surfaces planes, l'homogénéité en épaisseur étant quasiment impossible à réaliser sur des surfaces non planes.

Par ailleurs, ces techniques de dépôt sont réalisées en réacteur ouvert, ce qui ne permet pas de contrôler l'atmosphère proche du substrat et donc les réactions mises en jeu. En particulier, ces techniques ne peuvent pas être utilisées pour la fabrication de couches minces exemptes d'oxygène.

On connaît par ailleurs d'autres techniques de dépôt de couches minces telles que la pulvérisation chimique assurant un meilleur contrôle des conditions expérimentales et permettant le revêtement de surface complexe. Jusqu'à présent, ces techniques de pulvérisation chimique ont été exclusivement utilisées pour le

dépôt en phase vapeur (CVD) de couches minces à partir de précurseurs volatils généralement du type composés organométalliques et pour le dépôt par précipitation de sels non volatils (nitrates, acétates, chlorures) suivi d'un traitement thermique. Voir à cet effet les articles de J.L. Deschanvres et al., Journal de Physique, Colloque C5, supplément au n°5, mai 1989, "Thin film of ceramic oxides by modified CVD", p. 695-705, de G. Blandenet et al., Thin Solid Films, 77 (1981), p. 81-90, "Thin layers deposited by the Pyrosol Process" et de Albin et al., Advanced Ceramic Materials, vol. 2, n° 3A, 1987, p. 243-252, "Spray pyrolysis processing of optoelectronic materials", et le document FR-A-2 110 622.

Ces dépôts sont effectués à haute température, c'est-à-dire à des températures supérieures à 400°C entraînant une consommation d'énergie importante et donc un prix de revient des dispositifs en couches minces obtenus généralement élevé.

De plus, ces techniques haute température limitent le choix des substrats sur lesquels peuvent être réalisés ces dépôts à des substrats résistant thermiquement, ce qui limite leurs champs d'application.

L'invention a pour objet un procédé de dépôt d'une couche mince de polymère permettant de remédier aux différents inconvénients mentionnés ci-dessus. Elle permet, par rapport aux techniques classiques sol-gel, une croissance continue du dépôt permettant un contrôle d'épaisseur très précis ainsi qu'un contrôle de l'atmosphère environnant le substrat et, par rapport aux techniques de pulvérisation chimique, un domaine d'applications plus grand et une mise en oeuvre plus simple et moins coûteuse.

En particulier, l'invention peut être mise en oeuvre par des petites et moyennes entreprises du fait de sa simplicité de mise en oeuvre et de son bas prix de revient. De plus, le dépôt peut être réalisé sur des surfaces gauches, convexes ou concaves.

De façon plus précise, l'invention a pour objet un procédé de dépôt d'une couche mince de polymère sur un substrat, comportant les étapes suivantes :

a) - préparation d'une solution contenant au moins un solvant et au moins un précurseur du polymère soluble dans le solvant, la concentration totale en précurseur étant de 0,05 à 2 mol/l,

b) - pulvérisation ultrasonore à haute fréquence, dans un réacteur fermé étanche, de la solution au-dessus du substrat entraînant le dépôt d'un sol de précurseur sur le substrat, celui-ci étant maintenu à une température inférieure à la température d'ébullition du solvant,

c) - séchage du sol déposé pour évaporer le solvant et former ainsi une couche solide dudit polymère.

Le séchage peut avoir lieu à température ambiante (20 à 25°C) ou bien à une température supérieure à l'ambiante, mais ne dépassant pas la température d'ébullition du solvant.

Le dépôt de polymère dans un réacteur fermé C.E.A. et étanche permet de contrôler l'atmosphère et donc de contrôler les réactions mises en jeu. En particulier, il est possible de travailler en atmosphère exempte d'oxygène et de former ainsi des couches solides exemptes d'oxygène, ce qui n'était pas possible dans les techniques sol-gel classiques.

Le procédé selon l'invention permet une croissance continue du dépôt à basse température (inférieure à 200°C).

Le dépôt a lieu à pression atmosphérique, ce qui rend le procédé encore plus intéressant.

Afin d'obtenir un dépôt homogène, la fréquence ultrasonore utilisée est choisie dans l'intervalle de 500 kHz à 3 MHz et de préférence entre 700 kHz à 1 MHz. En effet, la taille des gouttelettes vaporisées est directement liée à la fréquence ultrasonore ; le diamètre des gouttelettes diminue lorsque la fréquence ultrasonore augmente. Or, plus la taille des gouttelettes augmente, plus le dépôt obtenu est inhomogène. Inversement, si l'on travaille à trop haute fréquence, les solvants les plus visqueux ne peuvent plus être pulvérisés.

L'utilisation d'une technique de pulvérisation ultrasonore permet en outre un réglage simple et fiable de la production d'aérosols, par le niveau de puissance ultrasonore choisi permettant ainsi une maîtrise parfaite de la cinétique de dépôt. En outre, cette technique permet un meilleur contrôle de l'écoulement des fluides dans le réacteur.

Le polymère obtenu peut être un homopolymère ou un copolymère. Il peut être minéral, organique ou organométallique.

Le précurseur du polymère utilisé est en général un monomère ; l'étape c conduit donc à une polymérisation ou une copolymérisation du ou des monomères.

Toutefois, l'invention s'applique aussi à des précurseurs polymériques. Ainsi, lorsque l'on dispose d'un polymère soluble (oligomère), le procédé de l'invention permet son redépôt, à basse température, sur un substrat quelconque (par exemple ne tenant pas aux hautes températures) par pulvérisation ultrasonore suivi d'une simple évaporation du solvant. Ces étapes sont bien entendu réalisées en atmosphère contrôlée. On peut par exemple redéposer sous atmosphère neutre du polysilazane dissous dans du tétrahydrofuranne (THF).

La suite de la description ne concernera que l'utilisation d'un ou plusieurs monomères comme précurseurs du polymère.

Lorsque le polymère obtenu contient des atomes d'oxygène, la polymérisation est régie par deux réactions

indissociables l'une de l'autre, l'hydrolyse (action de l'eau) et la polycondensation. Parallèlement, lorsque le polymère obtenu est un composé exempt d'oxygène, la polymérisation peut consister en une étape d'ammonolyse (action avec de l'ammoniac) suivie d'une étape de polycondensation.

De façon avantageuse, on soumet la couche de polymère obtenue en c à un recuit entre 100 et 1300°C. Cette pyrolyse permet notamment l'obtention de couches minces (organominérales ou minérales) vitreuses, vitrocéramiques ou céramiques. Ces couches minces peuvent être des oxydes ou des non oxydes.

En particulier, l'invention permet l'obtention de couches minces de céramiques non oxydes de façon simple et à des températures comprises de préférence entre 500 et 1300°C, telles que des couches de fluorure, de carbure, de nitrure, de carbonitrure et d'oxynitrure.

Ces couches minces inorganiques non oxydes sont obtenues à partir de couches de polymères exemptes d'oxygène. A titre d'exemples, on peut citer la formation de polymères azotés (polysilazanes) par ammonolyse-condensation (action de l'ammoniac) de dichlorosilane, de trichlorosilane, de méthyl- ou éthyldichlorosilane. Comme autres réactions de copolymérisation, on peut citer également la co-condensation de diphénylméthyldichlorosilane et de diméthyldichloro-silane pour l'obtention, après séchage, d'une couche mince de polysilastyrène ou encore la co-réaction de méthyltrichlorosilane et d'hexaméthyldisilazane pour l'obtention, après séchage, de polysilazane. Ces couches minces de copolymères conduisent, après recuit sous atmosphère neutre ou réductrice, à des couches minces de carbure, nitrure, oxynitrure ou carbonitrure de silicium, aluminium, titane ou autres composés.

Le procédé de l'invention permet aussi l'obtention de couches mixtes organiques-inorganiques telles que des verres au silicium modifiés organiques, connus sous le nom de Ormosil ou encore des céramiques modifiées organiques connues sous le nom de Ormocer. La solution la plus simple pour obtenir ces couches mixtes consiste en une incorporation de groupements non hydrolysables (alkyle ou aryle) dans le polymère obtenu par réaction sol-gel des précurseurs adéquats.

Ces verres organiques et ces céramiques organiques ont l'avantage d'être obtenus à des températures de recuit de 100 à 200°C, ce qui permet de les déposer sur des substrats ne tenant pas aux hautes températures et en particulier de les déposer sur des substrats en polymère organique.

Le procédé de l'invention s'applique plus particulièrement aux dépôts de couches minces de composés inorganiques. Aussi, l'invention a pour objet un procédé de dépôt d'une couche mince d'au moins un composé inorganique d'au moins un métal, sur un substrat, comportant les étapes suivantes :

a') - préparation d'une solution contenant au moins un solvant et au moins un organométallique, soluble, hydrolysable ou ammonolysable, et polymérisable précurseur du composé, la concentration totale en précurseur étant de 0,05 à 2 mol/l.

b') - pulvérisation ultrasonore à haute fréquence, en présence d'eau ou d'ammoniac, de la solution au-dessus du substrat, dans le réacteur fermé étanche, entraînant le dépôt d'un sol dudit organométallique sur le substrat, celui-ci étant maintenu à une température inférieure à la température d'ébullition du solvant,

c') - séchage du sol déposé pour évaporer le solvant et polymériser l'organométallique, et

d') - recuit de la couche obtenue en c'.

En particulier, ces composés minéraux sont des oxydes. Dans ce cas, le composé organométallique hydrolysable précurseur du composé minéral est un alcoxyde. Le recuit a lieu à des températures comprises de préférence entre 200 et 800°C.

Lorsque l'on souhaite réaliser un dépôt d'oxyde mixte, on utilise généralement un alcoxyde de chacun des métaux entrant dans la composition de l'oxyde. Dans certains cas, on peut remplacer un des alcoxydes par un carboxylate. Dans ce cas, le carboxylate qui comporte de 1 à 5 atomes de carbone ne participe pas à la polymérisation.

Les alcoxydes ont l'avantage d'être extrêmement sensibles à l'humidité, ce qui permet de travailler en présence d'air. En outre, il est possible de trouver des alcoxydes pour la plupart des composés métalliques que l'on veut déposer. De plus, les alcoxydes peuvent être polymérisés à très basse température, et en particulier à une température proche de l'ambiante ; ils peuvent être polymérisés à des températures de 20 à 70°C et typiquement de 20 à 40°C.

Un alcoxyde métallique présente la formule $M(RO)_n$ où M représente un métal, n la valence du métal et R un radical alkyle.

Les métaux auxquels s'applique l'invention sont des métaux de transition tels que le titane, le zirconium, le tantale, le vanadium, mais aussi des métaux des colonnes II, III et IV tels que le magnésium, l'aluminium, l'indium, l'étain, le plomb ou le silicium.

R est un radical alkyle linéaire ou ramifié comportant de 1 à 5 atomes de carbone. Comme radicaux R on peut citer les radicaux méthyle, éthyle, n-propyle, isopropyle, n-butyle, isobutyle, n-pentyle, tertioamyle, etc.

Les deux réactions mises en jeu, pour des alcoxydes, lors de la polymérisation, sont :

– l'hydrolyse : substitution d'un radical alcoxy par un groupement OH dans la formule de l'alcoxyde, soit :

$$(RO)_{n-1}M\text{-}OR + HOH \rightarrow (RO)_{n-1}M\text{-}OH + ROH$$

– la polycondensation : création d'un groupement oxyde à partir de deux groupements alcoxy et OH, soit :

$$(RO)_{n-1}M\text{-}OH + RO\text{-}M\ (RO)_{n-1} \rightarrow (RO)_{n-1}M\text{-}O\text{-}M\ (RO)_{n-1} + ROH$$

On constate que chacune de ces deux réactions s'accompagne de la formation et de l'évaporation d'une molécule d'alcool.

Pour l'obtention de polymères non oxydes, l'ammonolyse et la polycondensation s'accompagnent de la formation et de l'évaporation d'une molécule d'amine.

Selon l'invention, la concentration en précurseur du polymère doit être choisie dans la gamme de 0,05 à 2 mol/l. Pour des concentrations plus élevées, on obtient des solutions trop visqueuses qui nuisent au processus de pulvérisation ultrasonore. De plus, pour des concentrations trop importantes, les inventeurs ont constaté, lors de la pulvérisation, un vieillissement rapide de la solution s'accompagnant d'une diminution importante du taux de pulvérisation au cours du temps. Ceci est dû à l'échauffement de la solution provoqué par l'agitation ultrasonore. Cet échauffement s'accompagne d'une polymérisation partielle de la solution et donc d'une augmentation de sa viscosité au cours du temps.

Dans le cas d'alcoxydes comme précurseurs du polymère, on utilise de préférence une concentration de 0,2 à 0,6 mol/l.

Par ailleurs, il est préférable de maintenir la solution à pulvériser à des températures proches de l'ambiante, c'est-à-dire très inférieures au point d'ébullition du solvant (par exemple 50°C inférieurs au point d'ébullition du solvant) de façon que la solution reste parfaitement stable et le taux de pulvérisation reste constant au cours du temps.

Les solvants utilisés dépendent du précurseur du polymère utilisé. De plus, ces solvants doivent présenter une faible viscosité de façon à assurer leur pulvérisation, par exemple inférieure à $5.10^{-3}$Pa.s (5 centipoises).

Comme solvants utilisables, on peut citer les alcools et les cétones inférieurs (ou à courte chaîne carbonée). Les alcools et les cétones utilisables dans l'invention comportent en général de 1 à 5 atomes de carbone.

Comme alcools on peut citer l'éthanol, le propanol, le butanol, etc., comme cétones, on peut citer l'acétone et l'acétylacétone.

De préférence, on utilise des solvants présentant une température d'ébullition relativement élevée, et de préférence supérieure à 80°C à pression atmosphérique. Aussi, on utilise avantageusement le n-butanol ou le n-propanol.

Dans le cas de dépôts non oxydes, on utilise par exemple le méthylcyclohexane, le THF ou le toluène.

La pulvérisation ultrasonore est effectuée en présence d'un gaz vecteur (ou porteur) et d'un gaz dilueur.

A niveau de puissance ultrasonore fixé, la quantité d'aérosol transportée est une fonction croissante du débit de gaz vecteur utilisé. Il est donc nécessaire d'ajuster ce dernier paramètre de façon à ce que tout l'aérosol pulvérisé soit transporté. Dans le cas contraire, une partie des gouttelettes formées coalesce et se recondense dans le liquide à pulvériser. En général, le débit de gaz vecteur est choisi entre 5 à 15 l/min. Ce gaz vecteur peut être réactif ou non.

La plupart des alcoxydes sont extrêmement hydrolysables au contact de l'air ambiant, lequel contient toujours un certain taux d'humidité. Néanmoins, lorsque l'alcoxyde est dissous dans un alcool avec une concentration suffisamment faible, la réactivité de l'alcoxyde devient à peu près nulle. Dans ces conditions, l'aérosol peut être transporté par l'air, même légèrement humide, sans risque d'hydrolyse prématurée des gouttelettes pendant le transport. Parallèlement, pour l'obtention de couches polymériques non oxydes, on peut utiliser comme gaz réactif l'ammoniac.

Lorsque la vitesse d'hydrolyse de l'alcoxyde ou tout autre précurseur hydrolysable polymérisable utilisé est lente, le solvant utilisé contient avantageusement de l'eau. De plus, il est possible d'accélérer la réaction d'hydrolyse en ajoutant des traces d'un acide minéral dans la solution tel que HCl ou $HNO_3$.

Lorsque le monomère est facilement hydrolysable, on utilise un solvant non aqueux.

Parallèlement, pour l'obtention de couches non oxydes, le solvant peut contenir ou non une amine primaire inférieure.

La réaction de dépôt est basée sur une hydrolyse ou une ammonolyse partielle du monomère précurseur du polymère à la surface du substrat. Pour une production donnée d'aérosol, c'est-à-dire pour un niveau de puissance ultrasonore et un débit de gaz vecteur fixés, deux paramètres complémentaires permettent de contrôler cette réaction : la température du substrat et le débit du gaz dilueur.

– Température du substrat : A température ambiante, les gouttelettes d'aérosol ne réagissent pas durant le transport et conduisent à un dépôt liquide. Lorsqu'on augmente la température de surface du substrat, le solvant s'évapore partiellement avant d'atteindre la surface, ce qui augmente la réactivité des gouttelettes du précurseur monomère avec les gaz présents (alcoxyde à l'air par exemple).

– Débit de gaz dilueur : A température de substrat constante, une augmentation du débit de gaz dilueur (et donc de la quantité d'eau ou d'ammoniac dissoute dans ce gaz) conduit à une augmentation du rapport

quantité d'eau ou d'ammoniac/quantité d'aérosol ainsi qu'à une meilleure séparation des gouttelettes qui sont ainsi plus faciles à évaporer au voisinage du substrat.

Dans les deux cas, la réactivité des gouttelettes du monomère précurseur (alcoxyde par exemple) est accrue.

Pour une température suffisamment proche de l'ambiante (20-50°C) et pour un débit de gaz dilueur suffisamment faible dont la valeur maximale dépend des paramètres expérimentaux (point d'ébullition du solvant, température du substrat), les gouttelettes conduisent à un dépôt liquide mince (quelques centièmes ou dizièmes de micromètres) et uniforme sur le substrat. Après dépôt (interruption de l'injection de gaz vecteur), en maintenant ouverte l'injection du gaz dilueur, la couche liquide réagit rapidement à l'air ou l'ammoniac en désorbant les molécules d'alcool ou d'amine formées lors de la réaction d'hydrolyse (ou d'ammonolyse)-polycondensation et celles constituant le solvant le cas échéant.

Le retrait lié à cette désorption peut être observé in situ par l'évolution dans le temps des couleurs correspondant aux franges d'interférences dues aux réflexions multiples aux interfaces film-air et film-substrat.

L'évaporation du solvant (par exemple alcool) est généralement très rapide : elle ne dure que quelques dizaines de secondes pour des films d'alcoxyde de titane ou de ziconium, de quelques dizièmes de micromètre d'épaisseur. Après évacuation du solvant, le film polymère apparaît dense et parfaitement transparent.

Pour une température suffisamment proche du point d'ébullition du solvant (50-120°C dans le cas du n-butanol), celui-ci s'évapore presque entièrement avant que les gouttelettes n'atteignent le substrat. Les gouttelettes d'alcoxyde s'écrasent à la surface du substrat sur lequel elles se polymérisent instantanément. On obtient ainsi un revêtement dense sec et continu constitué d'une multitude de particules polymérisées en forme de disques applatis de quelques dizaines de micromètres de diamètre et de quelques dizaines de nanomètres d'épaisseur. Ces particules correspondent à l'impact des gouttelettes écrasées sur le substrat.

Une augmentation du débit de gaz dilueur, en augmentant la réactivité des gouttelettes conduit au même type de dépôt à plus basse température. Les dépôts obtenus sont translucides. En effet, une diffusion du rayonnement lumineux est causée par les réflexions multiples aux interfaces entre gouttelettes écrasées.

La cinétique de croissance du film dépend du débit d'aérosol et de la densité du brouillard à la surface du substrat. Pour une cinétique de dépôt fixée par le niveau de puissance ultrasonore et le débit de gaz vecteur, l'épaisseur déposée est très précisément contrôlée par la durée d'une expérience, c'est-à-dire par l'intervalle de temps écoulé entre l'ouverture et la coupure du débit de gaz vecteur injecté dans la solution.

Pour des critères de tenue mécanique du film, l'épaisseur d'une couche mince ne doit pas dépasser une valeur limite qui dépend de la nature du couple substrat-dépôt et qui est généralement de l'ordre de 200nm.

En effet, des couches dont l'épaisseur excède 200nm apparaissent fissurées, soit immédiatement après dépôt : les fissures sont causées par le retrait d'alcool ou d'amine des solvants, soit après traitement thermique pour l'obtention d'une phase vitreuse ou cristallisée : les fissures proviennent des contraintes mécaniques créées lors du refroidissement après recuit et sont liées à la différence d'expansion thermique du dépôt et du substrat.

En revanche, des films d'épaisseurs inférieures à 200nm apparaissent totalement exempts de fissure. Pour des épaisseurs supérieures, un procédé de dépôt selon l'invention de plusieurs couches successives avec répétition de cycles dépôt-recuit permet d'obtenir là encore des films non fissurés.

Le processus de dépôt multicouche peut être très rapide. Par exemple dans le cas d'un dépôt d'oxyde de titane, le cycle consiste en la répétition d'une triple séquence dépôt (30 sec.)-polymérisation (1 min)-recuit (3 min à 500°C) dont la durée totale n'excède généralement pas cinq minutes pour une épaisseur déposée après chaque séquence de l'ordre de 50 à 100nm.

D'autres caractéristiques et avantages de l'invention ressortiront mieux de la description qui va suivre, donnée à titre illustratif et non limitatif, en référence aux dessins dans lesquels :

– la figure 1 est un schéma de principe d'un appareillage de dépôt sol-gel par pulvérisation ultrasonore permettant la mise en oeuvre du procédé conforme à l'invention,

– la figure 2 donne les variations du coefficient de transmission en fonction de la longueur d'onde utilisée pour des couches minces d'oxydes obtenues selon l'invention.

Le dispositif représenté sur la figure 1 permettant la mise en oeuvre du procédé conforme à l'invention comporte un récipient ou pot de pulvérisation 2 comportant à sa partie inférieure un transducteur piézoélectrique 4 (céramique en titanate de plomb-zirconium : PZT) connecté à un générateur d'ultrason 6 délivrant typiquement 100 W et une fréquence de 800 kHz. La pastille piézoélectrique 4 en forme de disque constitue le fond du pot de pulvérisation 2.

Afin d'assurer une hauteur h constante de la solution 5 à pulvériser dans le récipient 2, un réservoir 10 gradué à niveau constant mis en communication à la base du récipient 2, permet de contrôler in situ la quantité de liquide 5 consommée au fur et à mesure du dépôt. Cette hauteur h est égale à la distance focale de la pastille piézoélectrique 4. La focalisation des ondes ultrasonores à la surface du liquide permet l'expulsion de gouttelettes 12.

Un gaz vecteur réactif ou non est introduit dans la partie médiane du récipient 2 au moyen d'une conduite 14.

Une buse de transport 16 permet d'amener les aérosols dans une seconde zone (réacteur 18) de forme conique renfermant un porte-substrat 20 qui peut être chauffé à une température inférieure à la température d'ébullition du solvant à l'aide d'un système de chauffage 22, du type résistance électrique. La référence 24 représente le substrat sur lequel doit être effectué le dépôt de couches minces.

La partie supérieure du réacteur de dépôt 18 comporte une alimentation 26 en gaz dilueur généralement réactif. L'ensemble est fermé hermétiquement.

Le gaz vecteur peut être de l'air ou un gaz inerte tel que l'azote et le gaz dilueur peut être de l'air, de l'oxygène ou un mélange réducteur tel que $N_2$+$H_2$, ou $NH_3$, etc. Leur choix dépend du monomère précurseur.

Le réacteur de dépôt 18 peut être couplé à un four 28 de façon étanche afin d'effectuer le recuit de la couche de polymère déposée sur le substrat 24. Un système mécanique classique (non représenté) permet le déplacement du substrat 24 vers le four de recuit 28.

La régulation en température du porte-substrat 20 (diamètre 8 cm, puissance 500W) est assurée par un thermocouple.

Bien entendu, d'autres configurations du dispositif de mise en oeuvre du procédé conforme à l'invention peuvent être envisagées, notamment en ce qui concerne le réacteur de pulvérisation 2 et son système d'alimentation en ondes ultrasonores.

On donne ci-après des exemples de fabrication de couches minces d'oxyde conformément à l'invention. Dans les exemples 1 à 17 ci-après, on utilise 50% de la puissance nominale (100W) du générateur d'ultrason de la figure 1, de l'air comme gaz vecteur, un débit de gaz vecteur de 10l/min, un débit d'aérosol de 200cm$^3$/h et une concentration en monomère précurseur de 0,2mol/l.

EXEMPLES 1 à 7

Dans ces exemples, on utilise du butoxyde de titane comme précurseur du polymère. Dans ces exemples, on fait varier la nature du solvant, le débit du gaz dilueur ainsi que la température du substrat.

Selon que le substrat est porté à une température proche du point d'ébullition du solvant ou à une température éloignée de ce point d'ébullition, le polymère obtenu ne présente pas les mêmes caractéristiques optiques. Les résultats sont portés dans le tableau I.

Dans les exemples 8 à 17 suivants, on fait de plus varier la nature du monomère précurseur. Par ailleurs, le dépôt de polymère est suivi d'un recuit de 1 à 2 heures à 500°C après un cycle multidépôt de une ou plusieurs séquences.

Ces dépôts de couches minces ont été réalisés sur du verre, du silicium monocristallin et des cristaux de grenat, de gallium-gadolinium (GGG) ; la durée de chaque recuit lors du processus multidépôt est de 3 min. Les résultats sont portés dans les tableaux II et III.

Les films obtenus sont parfaitement transparents et présentent des caractéristiques optiques (transmission, indice de réfraction), identiques à celles obtenues par dépôt sol-gel classique.

Les exemples 8 à 12 suivants (tableau II) sont relatifs aux dépôts d'oxydes monométalliques.

EXEMPLES 8 à 10 : Couche mince d'oxyde de titane

De l'anatase $TiO_2$ est formée par recuit à 500°C pendant 60 min d'une couche polymère déposée à 30-40°C à partir d'une solution de butoxyde ou de propoxyde de titane puis polymérisée durant 1 min à cette température. Des complexants tels que la diéthanolamine peuvent être incorporés avantageusement à la solution afin d'en ralentir le vieillissement (précipitation ou gélification). Le dépôt cristallisé obtenu après recuit est homogène, transparent et se caractérise par une très fine granulométrie (taille des grains inférieure à 30 nm).

L'indice de réfraction dans le visible (voisin de 2,2) est comparable à celui de films déposés par le procédé sol-gel classique, mais sensiblement plus faible que celui du matériau massif (2,50-2,60). Ceci est caractéristique des films d'oxydes de titane déposés sur du verre par le procédé sol-gel et s'explique par une contamination par les ions alcalins du substrat lors du recuit à 500°C.

EXEMPLE 11 : Couche mince d'oxyde de zirconium

La zircone cubique $ZrO_2$ est déposée dans des conditions analogues à celles du dépôt précedent de $TiO_2$ à partir d'une solution de butoxyde de zirconium. Les caractéristiques morphologiques sont similaires à celles du dépôt précédent. L'indice de réfraction (voisin de 2,0) est proche de celui du matériau massif (2,10-2,20).

EXEMPLE 12 : Couches minces d'oxyde de silicium

Un dépôt vitreux de silice est formé après recuit à 500°C d'un dépôt de polymère obtenu à partir d'une solution d'éthoxyde de silicium. L'éthoxyde de silicium s'hydrolyse très lentement.

De plus, l'éthoxyde de silicium présente une forte tension de vapeur (point d'ébullition à 165,8°C à pression atmosphérique). La réaction de polymérisation s'accompagne donc d'une évaporation partielle des molécules d'alcoxyde n'ayant pas encore polymérisé.

Afin d'éviter cette évaporation et d'accélérer la polymérisation de la couche, on utilise une méthode connue dans la synthèse de silice par voie sol-gel : de l'eau et un catalyseur acide tel que HCl sont ajoutés à la solution et permettent de préhydrolyser l'éthoxyde de silicium et de le rendre non volatil.

Sur la figure 2, on a représenté des spectres de transmission dans le visible pour différentes couches minces déposées sur du verre, les courbes a, b, c, d, e et f, correspondent respectivement à un dépôt de $SiO_2$ de 350nm, $ZrO_2$ de 150 nm, $ZrO_2$ de 50 nm, $TiO_2$ de 300 nm, $TiO_2$ de 100 nm, et $TiO_2$ de 5 nm.

Ces courbes donnent a variation du pourcentage de transmission (T%) en fonction de la longueur d'onde exprimée en micromètre.

Les exemples 13 à 17 suivants (tableau III) sont relatifs aux dépôts d'oxydes mixtes. Pour ces exemples, le solvant est le butanol, sauf pour l'exemple 14 pour lequel 25% en volume d'acide acétique ont été ajoutés, la température du substrat est de 40°C et le débit de gaz dilueur est de 11 l/min dans le cas du $PbTiO_3$ et de 8 l/min dans le cas des dépôts Si-Zr-O.

L'épaisseur des dépôts varie de 40 à 400 nm.

La microanalyse X par dispersion d'énergie a été utilisée pour l'étude de la composition des dépôts.

A une température de substrat de 30 à 40°C, les gouttelettes composant l'aérosol se déposent en phase liquide sans avoir réagi durant le transport. La composition du dépôt est donc sensiblement identique à celle de la solution source, ce qui permet un contrôle simple de la stoechiométrie du film obtenu après recuit.

Lorsqu'on dispose d'espèces polymérisant rapidement (alcoxydes de zirconium ou de titane par exemple), il est possible d'obtenir un film multicomposant homogène et transparent même lorsque les espèces supplémentaires prises séparément polymérisent lentement ou pas du tout : lors de l'étape de polymérisation, ces dernières sont rapidement emprisonnées dans une matrice polymère dans laquelle elles restent intimement dissoutes. Ceci évite tout problème de ségrégation granulaire et conduit à l'obtention de couches qui restent transparentes après recuit.

EXEMPLES 13 à 14 : Couches minces de titanate de plomb

Un dépôt cristallisé de titanate de plomb $PbTiO_3$ est obtenu dans les conditions définies au tableau III. La solution source est composée un mélange dans des proportions stoechiométriques de butoxyde de titane et d'acétate trihydraté (Ex. 14) ou d'éthylhexanoate de plomb (Ex. 13). Ces composés précurseurs sont dissous dans le butanol. Dans le cas de l'acétate de plomb (Ex. 14), 25% en volume d'acide acétique sont ajoutés à la solution.

Pour les deux composés précurseurs au plomb, le dépôt mixte $PbTiO_3$ obtenu après recuit est parfaitement transparent et présente une très fine granulométrie identique à celle des dépôts de $TiO_2$ (Ex. 8 à 10), alors que lorsque ces composés sont utilisés seuls, le dépôt de PbO obtenu après recuit présente un aspect laiteux et se compose d'agrégats granulaires disjoints de quelques micromètres de diamètre.

EXEMPLES 15 à 17 : Dépôt de couches minces vitreuses d'oxyde de zirconium et de silicium.

Des dépôts amorphes dans le système $SiO_2$-$ZrO_2$ sont obtenus dans des conditions (dépôt, polymérisation, recuit) analogues à celles du dépôt de $ZrO_2$ (Ex. 11). La solution source est composée d'un mélange de butoxyde de zirconium et d'éthoxyde de silicium dissous dans le n-butanol.

Pour des compositions riches en $SiO_2$ (plus de 50% en mole), en raison de sa cinétique très ente de polymérisation et de sa volatilité, une partie de l'éthoxyde de silicium n'ayant pas réagi avec le butoxyde de zirconium s'évapore lors de l'étape de polymérisation. Ceci conduit à une stoechiométrie de la couche déficitaire en silicium par rapport à la composition de la solution source (cas de l'exemple 16).

Un simple traitement préliminaire de la solution d'éthoxyde de silicium (cas de l'exemple 17) par reflux durant quelques heures (5 h) à 95°C environ, avant adjonction du butoxyde de zirconium, permet d'éviter cet inconvénient. L'ajout de quelques fractions d'eau et de traces d'acide ($HNO_3$, HCl) permet d'activer la préparation de la solution par action catalytique. Ce traitement préliminaire conduit à une hydrolyse partielle de l'éthoxyde de silicium qui forme un silanol soluble du type $(OR)_3Si$-OH.

La solution de silanol est ensuite mélangée à la solution de butoxyde de zirconium dans la concentration

voulue puis pulvérisée.

Lors de l'étape de polymérisation post-dépôt, les éthoxysilanols polycondensent rapidement - sans s'évaporer - avec les molécules de butoxyde de zirconium. Ce traitement conduit à des dépôts polymères dont la stoechiométrie est directement contrôlée par la composition de la solution source.

Les dépôts d'oxydes mixtes recuits à 500°C sont optiquement transparents. Leur surface est parfaitement lisse et ne présente aucune ségrégation granulaire (microscopie électronique). Les dépôts sont amorphes aux rayons X même lorsque la durée de recuit dépasse 24 heures.

Ces caractéristiques suggèrent la nature vitrocéramique (microcristaux de zircone dissous dans une matrice vitreuse de silice) ou vitreuse du dépôt.

Le procédé de l'invention permet donc le dépôt de couches minces sous forme de monocouches ou multicouches, polymères, de quelques dizaines à quelques centaines de nanomètres d'épaisseur.

Ce procédé permet une croissance continue à basse température (inférieure à 200°C) de polymères contrôlée par transport gazeux ; une cinétique de croissance du polymère contrôlée par le débit d'aérosol transporté, c'est-à-dire par le niveau de puissance d'excitation ultrasonore et par le débit de gaz vecteur ; une épaisseur de dépôt polymère contrôlée par la durée écoulée entre l'ouverture et la coupure du flux de gaz vecteur ; une réaction de polymérisation contrôlée par le taux de dilution du monomère précurseur dans le solvant et le flux de gaz dilueur et par évaporation du solvant à la surface du substrat ; une stoechiométrie du polymère contrôlée par la composition de la solution source ; l'obtention d'un dépôt notamment vitreux (organominéral ou minéral), vitrocéramique ou céramique par recuit du polymère déposé ; une mise en oeuvre dans un réacteur intégré étanche permettant le contrôle de l'atmosphère de dépôt et de recuit et la possibilité d'enduction de surface gauche grâce à un écoulement uniforme de l'aérosol autour de l'objet à recouvrir.

TABLEAU I

| Exemples | Solvant | Débit de gaz dilueur (l/min) | Température du substrat (°C) | Aspect du dépôt polymère |
|---|---|---|---|---|
| 1 | Butanol | 15 | > 50 | Translucide |
| 2 | Butanol | 15 | 30 - 40 | Transparent |
| 3 | Propanol | 5 | > 40 | Translucide |
| 4 | Propanol | 5 | 30 | Transparent |
| 5 | Ethanol | 2 | 40 | Translucide |
| 6 | Ethanol | 15 | 30 | Translucide |
| 7 | Ethanol | 2 | 30 | Transparent |

TABLEAU II

| Exemples | Composé source | Solvant | Débit de gaz dilueur (l/min) | Température du substrat (°C) | Durée d'un cycle (dépôt + polym.) (min) | Nombre de séquences dépôt/recuit | Epaisseur nm | Caratéristiques structurales après recuit 1h à 500°C |
|---|---|---|---|---|---|---|---|---|
| 8 | Butoxyde ou propoxyde de titane | Butanol | 15 | 40 | (0,5 +1) | 1 - 4 | 50 -200 | Anatase $TiO_2$ (tétragonale a = 0,379 nm c = 0,951nm) |
| 9 | " | Propanol | 5 | 30 | (0,5 + 1) | 1 - 4 | 100 -400 | " |
| 10 | " | Ethanol | 2 | 30 | (0,5 + 1) | 1 - 4 | 80 - 320 | " |
| 11 | Butoxyde de zirconium | Butanol | 8 | 40 | (0,5 + 1) | 1 - 4 | 50--200 | Zircone $ZrO_2$ (cubique, a =0,509nm) |
| 12 | Ethoxyde de silicium | Butanol | 15 | 40 | (0,5 +1 ) | 1 | 350 | $SiO_2$ amorphe |

TABLEAU III

| Exemples | Composés source | Composition de la solution mole % | Composition de la couche mole % | Caractéristiques structurales après recuit à 500°C |
|---|---|---|---|---|
| 13 | butoxyde de titane ethylhexanoate de plomb | Ti = 0,50 Pb =0,50 | Ti = 0,51 Pb = 0,49 | Perovskite $PbTiO_3$ (cubique, a = 0,396nm) |
| 14 | butoxyde de titane acétate de plomb | Ti = 0,50 Pb = 0,50 | Ti = 0,52 Pb = 0,48 | " |
| 15 | butoxyde de zirconium ethoxyde de silicium | Si = 0,25 Zr = 0,75 | Si = 0,27 Zr = 0,73 | Amorphe |
| 16 | " | Si = 0,75 Zr = 0,25 | Si = 0,66 Zr = 0,34 | " |
| 17 | " | Si = 0,75 Zr = 0,25 | Si = 0,75 Zr = 0,25 | " |

## Revendications

1. Procédé de dépôt d'une couche mince de polymère sur un substrat, comportant les étapes suivantes :
   a) - préparation d'une solution (5) contenant au moins un solvant et au moins un précurseur du polymère soluble dans le solvant, la concentration totale en précurseur étant de 0,05 à 2 mol/l,
   b) - pulvérisation (12) ultrasonore à haute fréquence, dans un réacteur fermé étanche (18), de la solution au-dessus du substrat (24) entraînant le dépôt d'un sol de précurseur sur le substrat, celui-ci étant maintenu à une température inférieure à la température d'ébullition du solvant,
   c) - séchage (28) du sol déposé pour évaporer le solvant et former ainsi une couche solide dudit polymère.

2. Procédé selon la revendication 1, caractérisé en ce que le précurseur est un monomère.

3. Procédé selon la revendication 1, caractérisé en ce que le précurseur est un oligomère.

4. Procédé selon l'une quelconque des revendications 1 à 3, caractérisé en ce que le précurseur est un organométallique.

5. Procédé selon l'une quelconque des revendications 1 à 4, caractérisé en ce que la solution contient de 0,2 à 0,6 mol/l de précurseur.

6. Procédé selon l'une quelconque des revendications 1 à 5, caractérisé en ce que le substrat est maintenu, au cours de l'étape b, à une température choisie dans l'intervalle de 20 à 70°C.

7. Procédé selon l'une quelconque des revendications 1 à 6, caractérisé en ce que la fréquence ultrasonore est choisie dans la gamme de 500 kHz à 3 MHz.

8. Procédé selon l'une quelconque des revendications 1 à 7, caractérisé en ce que la pulvérisation est réalisée en présence d'un gaz dilueur dont le débit est choisi dans l'intervale allant de 2 à 15 l/min.

9. Procédé de dépôt d'une couche mince d'au moins un composé inorganique d'au moins un métal, sur un substrat (24), selon l'une quelonque des revendications 1 à 8, comportant les étapes suivantes :
   a') - préparation d'une solution (5) contenant au moins un solvant et au moins un organométallique, hydrolysable ou ammonolysable et polymérisable, précurseur du composé, la concentration totale en précurseur étant de 0,05 à 2 mol/l,
   b') - pulvérisation (12) ultrasonore à haute fréquence en présence d'eau ou d'ammoniac, de la solution au-dessus du substrat dans le réacteur fermé étanche (18), entraînant le dépôt d'un sol dudit organométallique sur le substrat, celui-ci étant maintenu à une température inférieure à la température d'ébullition du solvant,
   c') - séchage (28) du sol déposé pour évaporer le solvant et polymériser l'organométallique, et
   d') - recuit de la couche obtenue en c'.

10. Procédé selon la revendication 9, caractérisé en ce que le recuit est effectué entre 100 et 1300°C.

11. Procédé selon la revendication 9 ou 10, caractérisé en ce que l'organométallique est un alcoxyde et le composé inorganique un oxyde, la température de recuit étant choisie entre 200 et 800°C.

12. Procédé de dépôt d'une couche mince d'un oxyde d'au moins un premier et un second métal selon l'une quelconque des revendications 9 à 11, caractérisé en ce que l'on utilise un alcoxyde d'un premier métal et un organométallique du second métal pouvant être un alcoxyde ou un carboxylate dissous dans le solvant.

13. Procédé selon l'une quelconque des revendications 9 à 12, caractérisé en ce que le solvant est un alcool.

14. Procédé selon l'une quelconque des revendications 9 à 13, caractérisé en ce que le solvant est le n-butanol ou le n-propanol.

**15.** Procédé selon l'une quelconque des revendications 9 à 14, caractérisé en ce que le métal est choisi parmi le titane, le zirconium, le silicium et le plomb.

**16.** Procédé selon l'une quelconque des revendications 11 à 15, caractérisé en ce que le substrat est maintenu entre 20 et 40°C.

**17.** Procédé selon la revendication 9 ou 10, caractérisé en ce que le composé inorganique est un oxyde de la famille des ORMOCER et ORMOSIL, la température de recuit étant choisie entre 100°C et 200°C.

**18.** Procédé selon la revendication 9 ou 10, caractérisé en ce que le composé inorganique est choisi parmi les fluorures, carbures, nitrures, carbonitrures et oxynitrures, la température de recuit étant choisie entre 500°C et 1300°C.

FIG. 1

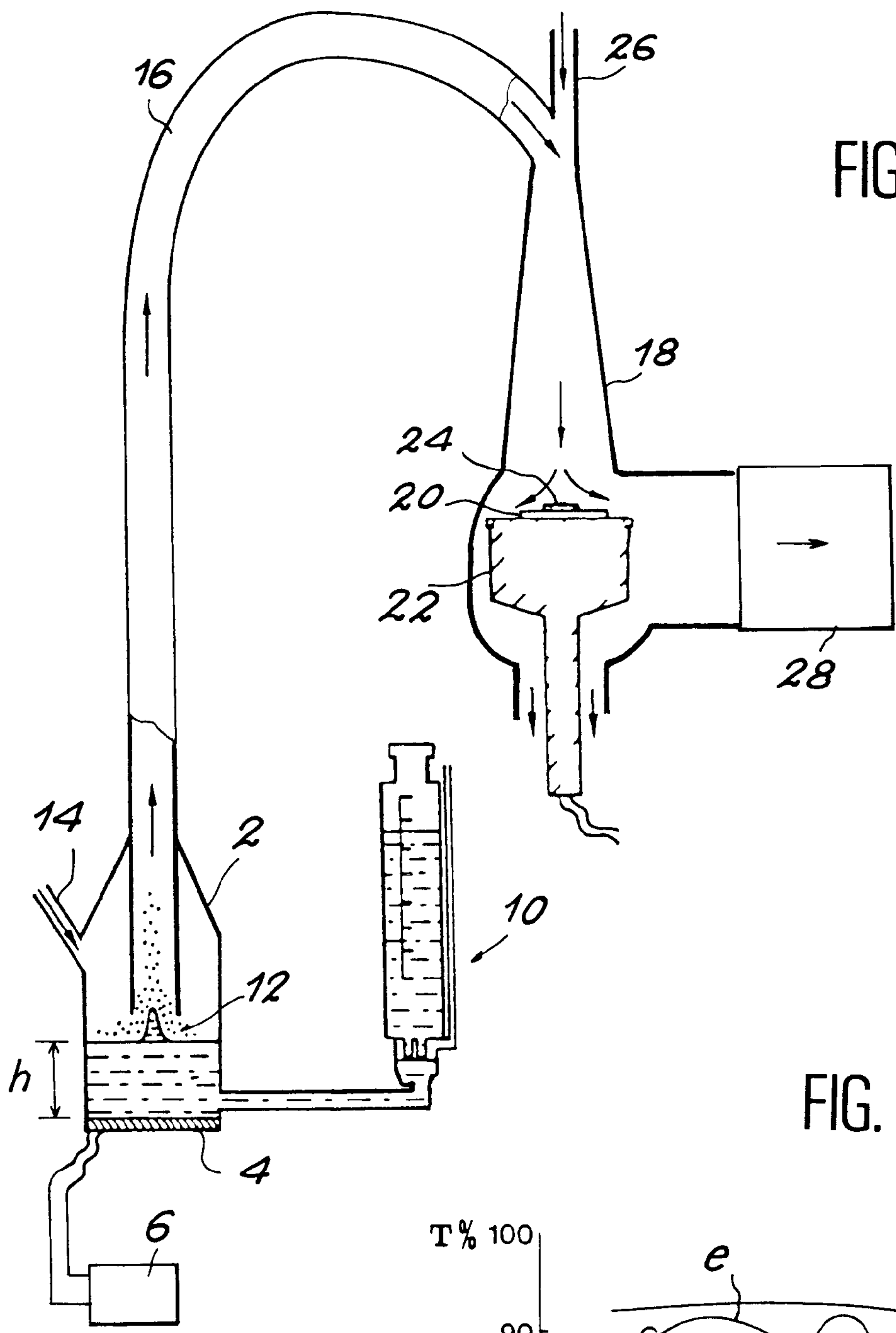
16
26
18
24
20
22
28
14
2
10
12
h
4
6

FIG. 2

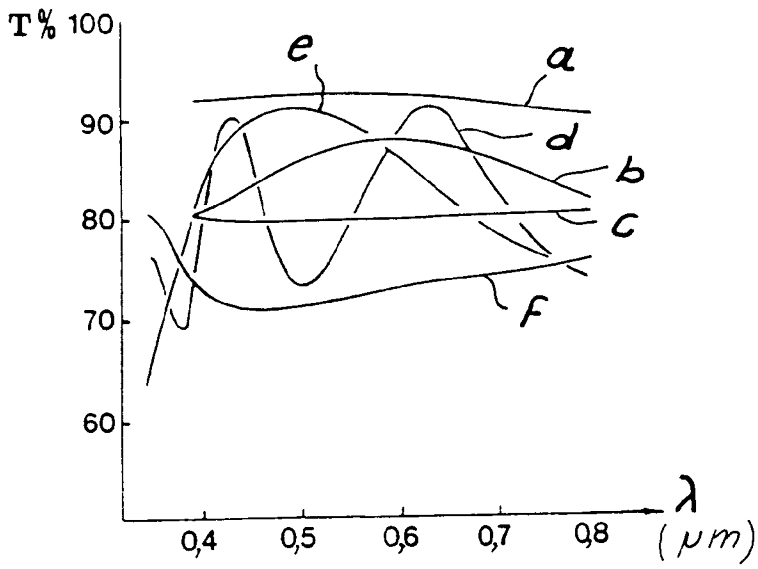
T %
100
90
80
70
60
e
a
d
b
c
f
λ
0,4
0,5
0,6
0,7
0,8
(μm)

Office européen des brevets

# RAPPORT DE RECHERCHE EUROPEENNE

Numero de la demande

EP 91 40 3057
Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-0 294 221 (TOA NENRYO KOGYO K.K.)<br>* revendications 1,4,6; colonne 3, ligne 53 à colonne 4, ligne 14; colonne 5, lignes 51-57; colonne 6, lignes 13-28; colonne 7, lignes 13-30; exemple 1 *<br>--- | 1-5,8-13 | C04B41/87<br>B05B17/06<br>B05D1/02<br>C03B19/12<br>C03B37/016<br>C03C17/00<br>C09D1/00<br>C09D183/00<br>C23C18/00<br>H01L39/24 |
| X | WORLD PATENTS INDEX LATEST<br>Section Ch,<br>Derwent Publications Ltd., London, GB;<br>Class L, AN 88-366214 | 1-4,7,9,<br>11,12 | |
| A | * abrégé *<br>& PATENT ABSTRACTS OF JAPAN<br>vol. 13, no. 105 (C-575)13 Mars 1989<br>& JP-A-63 277 770 ( NIPPON SODA CO.LTD. ) 15 Novembre 1988<br>--- | 8,10 | |
| X | US-A-4 701 348 (G.F.NEVILLE)<br>* colonne 2, lignes 8-30; colonne 3, lignes 22-35 *<br>--- | 1-3,6 | |
| X | EP-A-0 103 505 (COMMISSARIAT A L'ENERGIE ATOMIQUE)<br>* revendications 1,2,5,8,9; exemples 1,3 *<br>--- | 1-4,6,7,<br>9,10,15,<br>16<br>/ | **DOMAINES TECHNIQUES RECHERCHES (Int. Cl.5)**<br>B05B<br>B05D<br>C03B<br>C03C<br>C23C<br>C04B |
| X | WORLD PATENTS INDEX LATEST<br>Section Ch,<br>Derwent Publications Ltd., London, GB;<br>Class M, AN 89-065525<br>* abrégé *<br>& PATENT ABSTRACTS OF JAPAN<br>vol. 13, no. 190 (C-593)8 Mai 1989<br>& JP-A-01 017 873 ( MATSUMOTO SEIYAKU KOGYO KK )<br>20 Janvier 1989<br>---<br>-/-- | 1,9 | |

Le présent rapport a été établi pour toutes les revendications

| Lieu de la recherche | Date d'achèvement de la recherche | Examinateur |
|---|---|---|
| LA HAYE | 24 FEVRIER 1992 | STROUD J.G. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Office européen des brevets

# RAPPORT DE RECHERCHE EUROPEENNE

Numero de la demande

EP 91 40 3057
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X<br>A | WORLD PATENTS INDEX LATEST<br>Section Ch,<br>Derwent Publications Ltd., London, GB;<br>Class M, AN 87-295888<br>* abrégé *<br>& PATENT ABSTRACTS OF JAPAN<br>vol. 12, no. 70 (C-479)4 Mars 1988<br>& JP-A-62 207 870 ( MITSUBISHI ELECTRIC CORP. )<br>12 Septembre 1987<br>--- | 1-4<br>8,9 | |
| P,X | EP-A-0 411 499 (HOECHST AG)<br>* le document en entier *<br>--- | 1 | |
| X | PATENT ABSTRACTS OF JAPAN<br>vol. 11, no. 92 (E-491)24 Mars 1987<br>& JP-A-61 244 025 ( TOA NENRYO KOGYO KK ) 30 Octobre 1986<br>--- | 1,9 | |
| X | WORLD PATENTS INDEX LATEST<br>Section Ch,<br>Derwent Publications Ltd., London, GB;<br>Class L, AN 90-012881<br>& JP-A-01 294 525 (TAO NENRYO KOGYO KK) 28 Novembre 1989<br>* abrégé *<br>--- | 1,9 | DOMAINES TECHNIQUES RECHERCHES (Int. Cl.5 ) |
| D,A | FR-A-2 110 622 (COMMISSARIAT A L'ENERGIE ATOMIQUE)<br>* Figure 1; revendications; page 5, lignes 16-35; page 6, lignes 15-20 *<br>--- | 1,5,7-9 | |
| A | WORLD PATENTS INDEX LATEST<br>Section Ch,<br>Derwent Publications Ltd., London, GB;<br>Class L, AN 90-338380<br>& JP-A-02 243 504 (KOBE STEEL KK) 27 Septembre 1990<br>* abrégé *<br>---<br>-/-- | 1,9,12 | |

Le présent rapport a été établi pour toutes les revendications

| Lieu de la recherche | Date d'achèvement de la recherche | Examinateur |
|---|---|---|
| LA HAYE | 24 FEVRIER 1992 | STROUD J.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Office européen des brevets

# RAPPORT DE RECHERCHE EUROPEENNE

Numero de la demande

EP 91 40 3057
Page 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| D,A | ADVANCED CERAMIC MATERIALS, vol.2, no.3A, 1987, pages 243-252; D.S.ALBIN et al.:"Spray pyrolysis processing of optoelectronic materials." * page 246 * ----- | 1 | |
| | | | DOMAINES TECHNIQUES RECHERCHES (Int. Cl.5 ) |

Le présent rapport a été établi pour toutes les revendications

| Lieu de la recherche | Date d'achèvement de la recherche | Examinateur |
|---|---|---|
| LA HAYE | 24 FEVRIER 1992 | STROUD J.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)